## Europäisches Patentamt
## European Patent Office
## Office européen des brevets

(19)

(11) Numéro de publication: **0 252 820**
**A1**

# (12) DEMANDE DE BREVET EUROPEEN

(21) Numéro de dépôt: **87401546.4**

(22) Date de dépôt: **02.07.87**

(51) Int. Cl.⁴: **H 01 L 31/08**
G 01 T 1/29

(30) Priorité: **08.07.86 FR 8609893**

(43) Date de publication de la demande:
**13.01.88 Bulletin 88/02**

(84) Etats contractants désignés: **DE GB IT NL**

(71) Demandeur: **THOMSON-CSF**
**173, Boulevard Haussmann**
**F-75379 Paris Cédex 08 (FR)**

(72) Inventeur: **Micheron, François**
**THOMSON-CSF SCPI 19, avenue de Messine**
**F-75008 Paris (FR)**

**Broussoux, Dominique**
**THOMSON-CSF SCPI 19, avenue de Messine**
**F-75008 Paris (FR)**

**Facoetti, Hugues**
**THOMSON-CSF SCPI 19, avenue de Messine**
**F-75008 Paris (FR)**

**Richard, Bénédicte**
**THOMSON-CSF SCPI 19, avenue de Messine**
**F-75008 Paris (FR)**

(74) Mandataire: **Turlèque, Clotilde et al**
**THOMSON-CSF SCPI 19, avenue de Messine**
**F-75008 Paris (FR)**

(54) **Détecteur d'image à photoconducteur à mémoire.**

(57) L'invention concerne un détecteur d'image à photoconducteur à mémoire. Un exemple de réalisation comporte essentiellement une couche (4) homogène et épaisse de 600 microns, constituée d'oxyde mixte de bismuth et de silicium, entre deux électrodes (3 et 5). L'épaisseur de la couche de photoconducteur (4) est choisie au moins égale à l'inverse de son coefficient d'absorption, pour la longueur d'onde du rayonnement X de l'image à capter, c'est-à-dire supérieure ou égale à 200 microns.

Pendant une phase d'écriture d'une image latente dans la couche de photoconducteur (4), celle-ci est polarisée par un générateur de tension continue (12) pour évacuer les électrons (7) libérés par le rayonnement X, en laissant subsister une charge d'espace créée par les trous (6) qui, eux, sont autopiégés. Au cours d'une phase de lecture de l'image latente, les électrodes (3, 5) sont reliées à un amplificateur de courant (8) et la couche de photoconducteur (4) est balayée par un faisceau lumineux (13) libérant des électrons qui compensent la charge d'espace de l'image latente, en créant un courant dans le circuit constitué par les électrodes (3, 5) et l'amplificateur de courant (8).

Application aux détecteurs d'image pour la radiologie.

FIG_1

EP 0 252 820 A1

## Description

Détecteur d'image à photoconducteur à mémoire

L'invention concerne un détectuer d'image à photoconducteur à mémoire, pour convertir en signal électrique une image portée un rayonnement, par exemple des rayons X. Dans ce type de détecteur d'image, une image latente est enregistrée sous la forme d'une répartition spatiale de charge d'espace, dans une couche de matériau photoconducteur à mémoire, puis une lecture de cette image latente est effectuée en compensant cette charge d'espace par des photoporteurs libérés par un faisceau lumineux balayant la couche de photoconducteur. La mémorisation dans le photoconducteur permet l'analyse et le traitement de l'image à un rythme quelconque, indépendant de la durée d'exposition du détecteur au rayonnement.

Il est connu, par le brevet US n° 4 547 670, de réaliser un détecteur d'image à photoconducteur à mémoire, comportant une couche pour piéger les électrons libérés par les rayons X, cette couche étant constituée de silicium amorphe contenant 5% d'hydrogène, ou de tellure de cadmium CdTe amorphe, ou d'arséniure de gallium GaAs amorphe, ou de sulfure de cadmium CdS amorphe. Un exemple de réalisation préférential comporte une couche de silicium amorphe constituée d'une première sous-couche contenant environ 5% d'hydrogène et d'une seconde sous-couche contenant approximativement 30% d'hydrogène. Ce détecteur comporte aussi deux électrodes permettant d'appliquer une polarisation à la couche de matériau photoconducteur pendant l'enregistrement d'une image, et permettant de mesurer l'intensité d'un courant correspondant à la compensation de la charge d'espace, pendant l'analyse de l'image latente au moyen du balayage par un faisceau lumineux.

Le silicium amorphe contenant 5% d'hydrogène a un niveau de piégeage situé dans la bande interdite, par conséquent des électrons transférés dans la bande de conduction sont piégés dans ce niveau de piégeage. Le nombre d'electrons ainsi piégés correspond à l'irradiation reçue en chaque point du détecteur. La répartition des électrons piégés correspond donc à la distribution de l'intensité des rayons X projetés sur le détecteur. Lors du balayage par un faisceau lumineux, les électrons piégés dans la première sous-couche de silicium sont excités par l'énergie optique et sont déplacés par un champ électrique créé au moyen des électrodes, en direction de la seconde sous-couche de silicium. Cette seconde sous-couche possède un niveau de piégeage inférieur à celui de la première sous-couche. Les électrons déplacés sont prélevés par une électrode et sont envoyés à un amplificateur de courant. Ce détecteur de type connu a pour inconvénients de nécessiter la réalisation de deux sous-couches distinctes dans le matériau photoconducteur et surtout d'avoir une faible efficacité d'absorption des rayons X car l'épaisseur des matériaux photoconducteurs amorphes qui sont préconisés, est toujours très faible, de l'ordre de 1 micron, pour des raisons technologiques. D'autre part, les matériaux qui sont préconisés ont, pour une épaisseur donnée, une faible efficacité pour l'absorption des rayons X.

Le but de l'invention est de remédier à ces inconvénients par des moyens simples. L'objet de l'invention est un détecteur comportant une couche de matériau photoconducteur homogène et d'épaisseur très supérieure à celle du matériau photoconducteur du détecteur de type connu, procurant une plus grande facilité de réalisation et une plus grande efficacité dans l'absorption des rayons X.

Selon l'invention un détecteur d'image à photoconducteur à mémoire comportant:
- une couche de matériau photoconducteur à mémoire, illuminé par un rayonnement porteur d'une image ;
- deux électrodes situées de part et d'autre de la couche de matériau photoconducteur ;
- des moyens pour polariser les électrodes pendant une phase d'enregistrement de l'image, afin de créer une charge d'espace dans la couche de matériau photoconducteur ;
- des moyens de balayage lumineux pour illuminer successivement chaque portion de la couche de matériau photoconducteur suivant un chemin prédéterminé ;
- des moyens, couplés aux deux électrodes pour fournir des signaux électriques représentant l'intensité du courant de décharge de la couche de matériau photoconducteur pendant le balayage,
est caractérisé en ce que la couche de matériau photoconducteur est homogène et a une épaisseur supérieure ou égale à l'inverse de son coefficient d'absorption, pour la longueur d'onde du rayonnement porteur de l'image.

L'invention sera mieux comprise et d'autres détails apparaitront à l'aide de la description suivante et des figures l'accompagnant :
- la figure 1 représente un premier exemple de réalisation du détecteur selon l'invention ;
- la figure 2 représente un second exemple de réalisation du détecteur selon l'invention ;
- la figure 3 représente une variante d'une partie de ce second exemple.

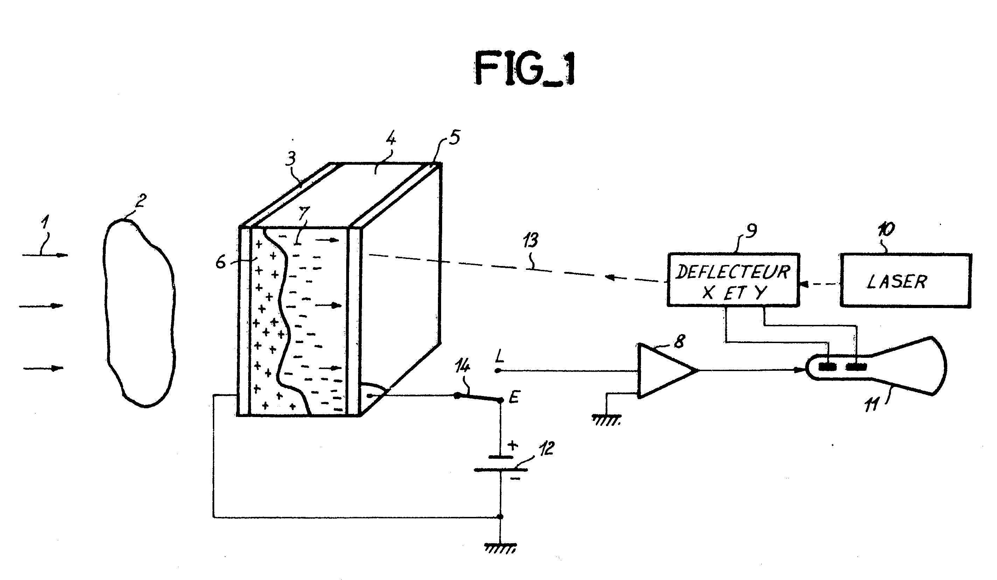

L'exemple de réalisation représenté sur la figure 1 comporte essentiellement : une couche 4, unique et homogène, de matériau photoconducteur ; une première électrode 3 et une second électrode 5 situées de part et d'autre de la couche 4 ; un générateur de tension continue, 12 ; un commutateur 14, à un circuit et deux positions ; un amplificateur de courant 8 ; un déflecteur de faisceau lumineux, 9 ; un laser 10 ; et une tube cathodique 11.

Dans cet exemple, un faisceau de rayons X, 1, est projeté à travers un objet 2 à radiographier. Les rayons X qui ont traversé l'objet 2 sont reçus par la couche 4 à travers l'électrode 3. L'électrode 3 est reliée à un potentiel de référence alors que l'électrode 5 est reliée au point commun du commutateur 14. Le commutateur 14 a une première position, notée E, dans laquelle le point commun est reliée à la borne positive du générateur de tension 12, et une seconde position, notée L, dans laquelle le point commun est relié à une entrée de l'amplificateur de courant 8. La borne négative du générateur 12 est reliée au potentiel de référence, de même qu'une seconde entrée de l'amplificateur de courant 8. Une sortie de l'amplificateur de courant 8 est reliée au wehnelt du tube cathodique 11.

Comme dans les détecteurs d'image de type connu comportant une couche de photoconducteur à mémoire, le fonctionnement du détecteur selon l'invention comporte une phase d'enregistrement d'une image latente, pendant laquelle le commutateur 14 est dans la position E, et une phase de lecture de l'image latente pendant laquelle le commutateur 14 est dans la position L. Pendant la phase de lecture, la couche 4 est balayée par un faisceau lumineux 13, à travers la seconde électrode 5 qui est transparente.

Le laser 10 fournit le faisceau lumineux 13 qui est dévié selon deux directions perpendiculaires, notées X et Y, par le déflecteur 9. Le déflecteur 9 possède deux sorties couplées respectivement à des électrodes de déviation verticale et de déviation horizontale, dans le tube cathodique 11, pour commander un balayage synchrone dans le tube cathodique 11. Le déflecteur 9 est de réalisation classique, à la portée de l'Homme de l'Art.

La couche 4 est constituée d'un matériau photoconducteur homogène ayant une épaisseur supérieure ou égale à l'inverse de son coefficient d'absorption, pour la longueur d'onde du rayonnement qui porte l'image à détecter. Cette épaisseur est beaucoup plus forte que dans le détecteur de type connu. Elle est suffisamment forte pour que l'absorption des rayons X soit pratiquement totale. Le nombre de créations de photoporteurs décroit exponentiellement à travers l'épaisseur de la couche 4, en décroissant de l'électrode 3 à l'électrode 5. La libération de photoporteurs est donc localisée essentiellement dans une zone proche de l'électrode 3, où arrivent les rayons X. Par contre, une zone proche de l'électrode 5 est pratiquemment isolante, en l'absence de lumière, et permet donc le stockage d'une charge d'espace constituant l'image latente.

Dans cet exemple, l'électrode 3 est une électrode ohmique constituée d'une couche d'aluminium évaporé dont l'épaisseur est de l'ordre de 0,1 micron, et l'électrode 5 est une électrode ohmique transparente constituée d'une couche d'oxyde d'étain de 0,01 micron.

Dans cet exemple, la couche 4 est constituée d'oxyde mixte, de bismuth et de silicium ($B_{12}$ $SiO_{20}$, appelé aussi BSO) pour lequel le coefficient d'absorption est égal à 50 cm$^{-1}$ pour des rayons X dont la longueur d'onde correspond à une énergie de 50KeV. Son épaisseur doit être égale ou supérieure à 200 microns, par exemple : 1,2mm. Les matériaux de la même famille, de formule $Bi_{12}$ $M O_{20}$, conviennent également, ainsi que les solutions solides de ces matériaux. Le métal M peut être du silicium, du germanium, du titane, ou du manganèse.

Le matériau photoconducteur de la couche 4 doit permettre la réalisation d'une charge d'espace. Il peut être constitué soit d'un matériau comportant des pièges pour l'un des types de photoporteurs, soit d'un matériau dans lequel les mobilités des deux types de photoporteurs sont très différentes, à tel point que l'une des types de photoporteurs puisse être considéré comme autopiégé, autrement dit ayant une mobilité nulle.

Dans une couche 4 constituée de BSO, les photons X libèrent des électrons 7 alors que des trous 6 restent immobiles. Pendant la phase d'écriture, le commutateur 14 étant dans la position E, l'électrode 5 est polarisée positivement par rapport à l'électrode 3. Le champ électrique créé dans la couche 4 déplace les électrons libérés, en direction de l'électrode 5. Les trous étant immobiles, il se forme une charge d'espace positive dont la répartition décroît exponentiellement dans l'épaisseur de la couche 4, de l'électrode 3 à l'électrode 5. D'autre part, la charge d'espace positive ainsi créée est proportionnelle en chaque point à l'intensité du rayonnement X reçu. Cette charge d'espace constitue l'image latente et subsiste pendant le temps de relaxation du photoconducteur dans l'obscurité, soit plusieurs heures dans le cas du BSO.

Pendant la phase de lecture, le commutateur 14 est mis dans la position L. Les électrodes 3 et 5 sont donc court-circuitées par l'entrée de l'amplificateur de courant 8. Le faisceau lumineux 13 balaye la couche 4 en traversant l'électrode transparente 5. Le faisceau lumineux 13 doit avoir une longueur d'onde comprise entre 450 et 650 nm dans le cas d'une couche 4 constituée de BSO. Le faisceau 13 est absorbé par la couche 4 et engendre des photoporteurs. Ceux-ci se déplacent dans le champ électrique de la charge d'espace constituant l'image latente et finissent par compenser cette charge d'espace, selon l'effet Dember. Le courant recueilli par les électrodes 3 et 5 constitue donc une mesure de la densité de charge d'espace en chaque point balayé par le faisceau 13. Le courant obtenu est, en moyenne, de deux électrons pour un photon X d'énergie 50Kev, absorbé dans une couche de 1,2 mm de BSO, soumis à une tension de 1KV et lu avec un faisceau 13 ayant une longueur d'onde de 450 nm et une puissance de 5 mw. On peut calculer, à partir de ce résultat, le nombre minimal de photons X détectables. Pour un pixel de surface 100 × 100 mm$^2$, et une épaisseur de 1,2 mm, ce nombre minimal est égal à 8 photons, soit une dose de 2 μR en 40 ms.

La saturation de la charge d'espace peut être calculée à partir de la densité des pièges à trous qui est d'environ $10^{18}$ /cm$^3$ dans le BOS, soit environ $10^{14}$ pièges par pixel. Cahque photon X étant capable de créer au maximum, $10^4$ trous piégés, la saturation est atteinte pour environ $10^{14}$ photons X par pixel. La dynamique du détecteur s'étend donc sur environ 9 décades.

Dans cet exemple, la lecture est effectuée en une seconde et la résolution spatiale est d'environ 3 pixels par mm, mais elle pourrait être augmentée par l'utilisation d'une couche 4 un peu moins épaisse, par exemple de 600 microns.

L'image captée par le détecteur est observée sur l'écran du tube cathodique 11. Naturellement, dans d'autres exemples de réalisation, le signal électrique fourni par la sortie de l'amplificateur de courant 8 peut aussi être numérisé, stocké, et traité de manière classique par un dispositif de calcul.

Dans cet exemple, le faisceau lumineux 13 est fourni par un laser de type He-Cd fournissant une lumière bleue permettant un balayage du côté de l'électrode 5. Dans d'autres exemples de réalisation, où la lumière est fortement absorbée par la couche 4 parce que la longueur d'onde du laser est inférieure à 550 nm, il est préférable de réaliser le balayage du côté de l'électrode 3, c'est-à-dire du côté où arrive le rayonnement X, de façon à engendrer les photoporteurs principalement dans la zone de charge d'espace. Dans ce cas, l'électrode 3 doit être transparente à la lumière.

De nombreux autres matériaux photoconducteurs à mémoire peuvent être utilisés pour constituer la couche 4. Notamment, il est possible d'utiliser un matériau à pièges pour électrons.

Le matériau photoconducteur peut être très absorbant pour le faisceau lumineux de lecture, pourvu que les photo-électrons créés à sa surface par le faisceau lumineux, se déplacent suffisamment dans l'épaisseur pour compenser la charge d'espace. C'est le cas du sélénium amorphe, pour lequel un faisceau lumineux de longueur d'onde 450 nm est absorbé par les premiers microns de la couche 4. Le sélinium amorphe est particulièrement approprié pour absorber les rayons X à basse énergie, et des procédés connus permettent de le fabriquer en couches de plusieurs centaines de microns, sur de grandes surfaces de l'ordre de plusieurs décimètres carrés.

D'autre part, la largeur de la bande interdite du matériau photoconducteur peut être telle que la faisceau lumineux de lecture ne soit que partiellement absorbé.

Enfin, la morphologie du matériau photoconducteur peut être telle que la lumière n'y pénètre pas. C'est le cas notamment des photoconducteurs polycristallins en poudre céramiques de BSO, et des photoconducteurs tels que les dispersée dans un liant, par exemple du BSO ou du PbO dans des matrices organiques ou minérales.

Une autre variante de réalisation concerne le procédé de lecture et consiste à réaliser une lecture simultanée de plusieurs pixels en parallèle.

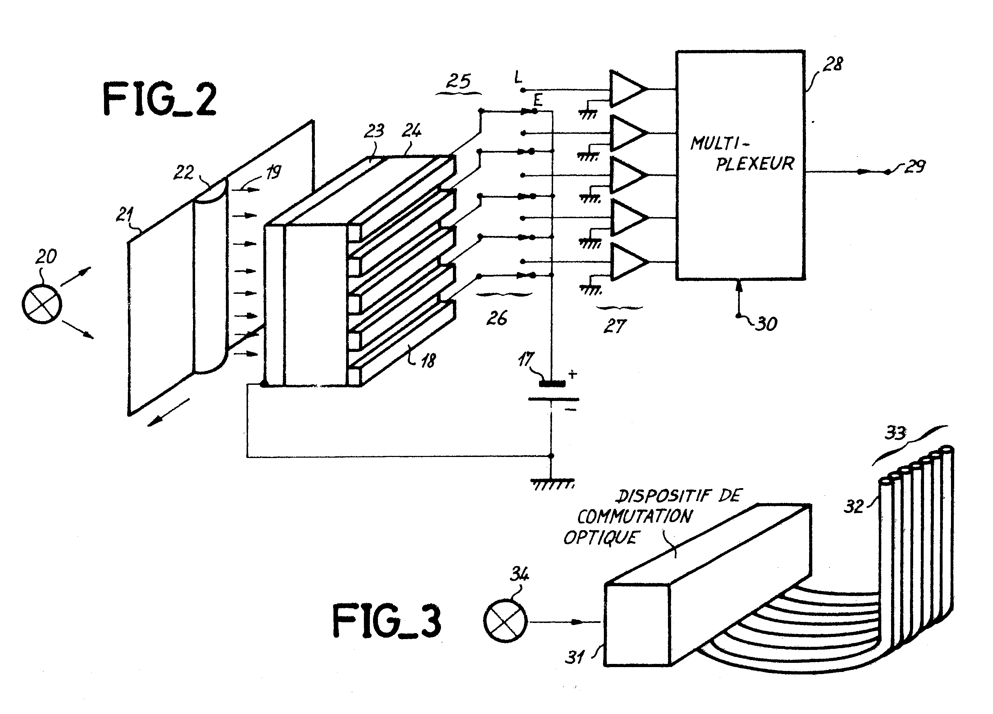

La figure 2 représente un second exemple de réalisation du détecteur selon l'invention, comportant essentiellement une couche 24, de matériau photoconducteur à mémoire ; une première électrode 23 et une seconde électrode 25 situées de part et d'autre de la couche 24, l'électrode 25 étant divisée en une pluralité de bandes 18 identiques. Pour plus de clarté le nombre de bandes 18 est seulement de cinq sur la figure 2, alors qu'en pratique il peut être de 1024, par exemple.

Dans cet exemple, la lecture est réalisée du côté de l'électrode 23 qui reçoit le rayonnement X. Ce rayonnement et l'objet qu'il traverse ne sont pas représentés sur cette figure pour plus de clarté. La lecture est effectuée par des rayons lumineux 19 projetés sur l'électrode 23 selon une ligne perpendiculaire à la direction des bandes 18 composant l'électrode 25. Ces rayons lumineux sont fournis par une source 20 de lumière cohérente et sont focalisés par une lentille cylindrique 22 entourée d'un écran opaque 21. L'écran opaque 21 et la lentille 22 sont déplacés, à une vitesse régulière, dans un plan parallèle au plan de l'électrode 23 afin de réaliser un balayage régulier de celle-ci.

Chaque bande 18 de l'électrode 25 est reliée électriquement au point commun d'un commutateur à un circuit et deux positions. Un ensemble 26 de cinq commutateurs permet de relier toutes les bandes 18 à la borne positive d'un générateur de tension 17 pendant la phase d'enregistrement d'une image latents, et permet de les relier respectivement à des entrées d'un ensemble 27 de cinq amplificateurs de courant pendant la phase de lecture. Ces cinq amplificatuers de courant ont des sorties reliées respectivement à cinq entrées d'un multiplexeur 28. Le multiplexeur 28 a une sortie reliée à une borne de sortie 29 pour fournir séquentiellement les valeurs de courant mesurées sur les bandes 18. Le multiplexeur 29 possède aussi une entrée de commande reliée à une borne 30 pour recevoir un signal de commande fourni, par exemple, par un dispositif de calcul destiné à traiter les images recueillies par le détecteur d'image. Ce dispositif de calcul commande aussi le déplacement de l'écran 21 et de la lentille 22 pour synchroniser le balayage de lecture.

Ce procédé de balayage permet de multiplier la vitesse de lecture. En outre, la division de l'électrode 5 provoque un fractionnement de la capacité électrique du détecteur. On peut démontrer que cela procure une augmentation de la détectivité du détecteur, c'est-à-dire de l'inverse du nombre de photons X fournissant un signal de puissance équivalente à celle du bruit.

D'autres dispositifs de balayage de lecture peuvent être utilisés : par exemple une fibre optique à diffusion latérale contrôlée, disposée à proximité de l'électrode 23, perpendiculaire à la direction des bandes 18 de l'électrode 25, et déplacée régulièrement dans un plan parallèle à l'électrode 23.

La figure 3 représente une autre variante du dispositif optique de balayage, comportant une nappe 33 de fibres optiques à diffusion latérale contrôlée, dont les fibres 32 sont perpendiculaires à la direction des bandes 18 et qui sont plaquées à la surface de l'électrode 23. Un dispositif de commutation optique 31 relie une source lumineuse 34 successivement à chacune des fibres 32 constituant la nappe 33. Sur cette figure 3 l'électrode 23, la couche 24, et l'électrode 25 ne sont pas représentées pour plus de clarté. Elles sont identiques à celles de l'exemple de réalisation de la figure 2, de même que les commutateurs 26, les amplificateurs 18 et le multiplexeur 28.

L'invention est applicable notamment aux détecteurs d'image pour les examens radiologiques, mais est applicable aussi aux détecteurs pour des rayonnements lumineux ou gammas.

## Revendications

1. Détecteur d'image à photoconducteur à mémoire comportant :
- une couche (4) de matériau photoconducteur à mémoire, illuminé par un rayonnement (1) porteur d'une image ;
- deux électrodes (3, 5) situées de part et d'autre de la couche (4) de matériau photoconducteur ;
- des moyens (12, 14) opour polariser les électrodes (3, 5) pendant une phase d'enregistrement de l'image, afin de créer une charge d'espace dans la couche (4) de matériau photoconducteur ;
- des moyens de balayage lumineux (9, 10) pour illuminer successivement chaque portion de la couche (4) de matériau photoconducteur suivant un chemin prédéterminé ;
- des moyens (8), couplés aux deux électrodes (3, 5) pour fournir des signaux électriques représentant l'intensité du courant de décharge de la couche (4) de matériau photoconducteur pendant le balayage,
caractérisé en ce que la couche (4) de matériau photoconducteur est homogène et a une épaisseur supérieure ou égale à l'inverse de son coefficient d'absorption, pour la longueur d'onde du rayonnement porteur de l'image.

2. Détecteur d'image selon la revendication 1, caractérisé en ce que le matériau photoconducteur à mémoire est tel que les mobilités des deux types de porteurs de charge sont très différentes, à tel point que l'un des deux types de porteurs peut être considéré comme immobile.

3. Détecteur d'image selon la revendication 2, caractérisé en ce que le matériau photoconducteur est constitué d'un oxyde mixte de bismuth et d'un métal M, $B_{12}$ M $O_{20}$ , le métal M pouvant être du silicium, ou du germanium, ou du titane, ou du manganèse.

4. Détecteur d'image selon la revendication 2, caractérisé en ce que le matériau photoconducteur est constitué d'oxyde mixte de bismuth et de silicium, $Bi_{12}$ $SiO_{20}$ , dit BSO, monocristallin.

5. Détecteur d'image selon la revendication 2, caractérisé en ce que le matériau photoconducteur est constitué d'oxyde mixte de bismuth et de silicium, $Bi_{12}$ $SiO_{20}$ , dit BSO, sous forme de céramique.

6. Détecteur d'image selon la revendication 2, caractérisé en ce que le matériau photoconducteur est constitué d'oxyde mixte de bismuth et de silicium, $Bi_{12}$ $SiO_{20}$ , ou d'oxyde de plomb PbO, en poudre dispersée dans un liant.

7. Détecteur d'image selon la revendication 2, caractérisé en ce que le matériau photoconducteur est constitué de sélénium amorphe.

8. Détecteur selon l'une des revendications 1 à 7, caractérisé en ce que l'une des électrodes (23, 25) est divisée en bandes (18) parallèles et identiques ;
en ce que le générateur de bayalage lumineux projete sur l'une des électrodes (23, 25) une ligne lumineuse (19), perpendiculaire aux bandes (18), et qui est déplacée le long des bandes (18) ;
et en ce que moyens (27), pour fournir des signaux électriques, fournissent des signaux représentant respectivement l'intensité de décharge de la couche (24) de matériau photoconducteur dans chacune des bandes (18).

9. Détecteur selon l'une des revendications 1 à 7, caractérisé en ce que l'une des électrodes (23, 25) est divisée en bandes (18) parallèles et identiques ;
en ce que le générateur de balayage lumineux comporte une nappe (33) de fibres optiques (32) à diffusion latérale contrôlée, appliquée contre l'une des électrodes (23, 25), perpendiculaire aux bandes (18), et couplée à une source lumineuse (34) par un dispositif de commutation optique (31) ;
et en ce que les moyens (27) pour fournir des signaux électriques, fournissent des signaux représentant respectivement l'intensité de décharge de la couche (24) de matériau photoconducteur dans chacune des bandes (18).

# FIG_1

# FIG_2

25

L

E

23 24

22 19

21

20

18

26

17 +

27

MULTI-
PLEXEUR

28

29

30

DISPOSITIF DE
COMMUTATION
OPTIQUE

33

32

34

FIG_3

31

0252820

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int Cl.4) |
|---|---|---|---|
| A | EP-A-0 092 157  (TOKYO SHIBAURA DENKI K.K.) <br> * Page 3, ligne 14 - page 6, ligne 26; revendications; figures 2,3 * | 1,2,8, 9 | H 01 L   31/08 <br> G 01 T    1/29 |
| | --- | | |
| A | GB-A-2 037 077  (GENERAL ELECTRIC CO.) <br> * En entier * | 1,7-9 | |
| | --- | | |
| A | FR-A-2 366 583  (SIEMENS AG) <br> * En entier * | 1,3-5 | |
| | --- | | |
| A | FR-A-2 521 781  (SIEMENS AG) <br> * En entier * | 1,3,8 | |
| | --- | | |
| A | GB-A- 748 302  (ZEISS IKON AG) | | **DOMAINES TECHNIQUES RECHERCHES (Int. Cl.4)** <br><br> H 01 L <br> G 01 T |
| | --- | | |
| A | US-A-4 010 376  (S.W. DUCK) | | |
| | ----- | | |

Le present rapport de recherche a été établi pour toutes les revendications

| Lieu de la recherche | Date d'achèvement de la recherche | Examinateur |
|---|---|---|
| LA HAYE | 02-09-1987 | VISENTIN A. |